# EUROPEAN PATENT SPECIFICATION

(11) **EP 0 709 967 B1**
(45) Date of publication and mention of the grant of the patent: **15.03.2000**
(21) Application number: 95307559.5
(22) Date of filing: 24.10.1995
(51) Int. Cl.: H03L 7/23

(54) **Phase locked loop circuit and method**
Phasenregelkreis und Verfahren dazu
Boucle à verrouillage de phase

(30) Priority: 26.10.1994 US 329367
(43) Date of publication of application: 01.05.1996
(73) Proprietor: HYUNDAI ELECTRONICS AMERICA, Milpitas, California 95035 (US)
(72) Inventor: Chen, Dao-Long, Fort Collins, CO 80525 (US)
(74) Representative: Gill, David Alan

(56) References cited:
- EP-A- 0 366 326
- DE-A- 3 400 289
- FR-A- 2 662 875
- US-A- 3 893 042
- US-A- 4 121 172

## Description

The present invention relates to a phase locked loop circuit and method, and in particular, but not exclusively, to a high-frequency phase locked loop circuit and method.

Phase-locked loop (PLL) circuits are widely used in electronic systems for clock recovery, frequency synthesis, frequency multiplication, and many other applications. Commonly known PLL circuits are discussed in the following references:
1. "Phaselock Techniques", by Floyd M. Gardner, John Wiley & Sons, 1979.
2. "Phase-locked Loops - Theory, Design, and Applications", by Dr. Roland E. Best, McGraw-Hill, 1984.

The maximum usable frequency of a PLL circuit is limited by delays within the circuit. One such delay is the intrinsic delay period in the oscillator cell for a given technology. For example, for a ring-oscillator based PLL circuit, a voltage-controlled oscillator within the PLL must have at least three oscillator stages for oscillation to be self-sustainable. Each oscillator stage includes an oscillator cell which produces two delay periods per cycle. Therefore, the overall delay for this PLL circuit is six delay periods per cycle.

Extra delay is caused by control transistors within the oscillator cells. The control transistors are added to control the oscillation frequency, but add extra capacitance and resistance which limit the maximum usable frequency of the PLL circuit.

When the PLL circuit is implemented using 0.7 micron complementary metal oxide semiconductor (CMOS) technology, the six delay periods plus the extra delay result in a maximum usable frequency of about 500 MHz. This frequency is much less than the maximum toggling frequency of logic gates within the circuit, which is at least 2 GHz.

Also, the maximum usable frequency is higher than the maximum design frequency in order for the PLL circuit to lock onto the target frequency. For example, if the design frequency is 500 MHz, the usable frequency must be higher than 500 MHz.

Frequencies higher than the maximum usable frequency of a given technology can usually only be implemented by moving to another technology that is more expensive. For example, silicon bipolar (Si Bipolar) or Gallium Arsenide (GaAs) technologies are typically chosen for high frequency circuits that do not work when implemented with the less expensive CMOS technology.

Therefore, it would be desirable to avoid using more expensive technologies to achieve higher usable frequencies by providing a CMOS PLL circuit which operates at a usable frequency significantly higher than the usable frequency of known CMOS PLL circuits.

US patent 3,893,042 discloses a lock indicator for phase locked loops and arranged to provide an output signal indicating that phase lock has been achieved.

The present invention seeks to provide for a phase-locked loop circuit and method having advantages over prior art circuits and methods:

According to one aspect of the present invention there is provided a phase locked loop circuit characterised by first phase-locked loop means having an input and an output, second phase-locked loop means having an input coupled to the input of said first phase-locked loop and having an output, and an exclusive-OR cirucit having first and second inputs coupled to the output of said first and second phase-locked loop means and having an output, wherein the circuit is arranged such that the said output of the exclusive-OR circuit provides a clock signal.

According to another aspect of the present invention there is provided a method of producing a clock signal characterized by the steps of producing a first signal having half the frequency of said clock signal by first phase-locked loop means, producing a second signal, having half the frequency of said clock signal and differing in phase by ninety degrees from the first signal by second phase-locked loop means, and coupling the first and second signals to an exclusive-OR logic element.

In accordance with the teachings of the present invention, as advantageous high-frequency phase locked loop circuit can be provided. The circuit can include a first phase-locked loop sub-circuit having an input and an output, a second phase-locked loop sub-circuit having an input coupled to the input of the first phase-locked loop circuit and an output, and an exclusive-OR circuit having first and second inputs coupled to the outputs of the first and second phase-locked loop sub-circuits and an output.

When implemented in using CMOS technology, the circuit of the present invention effectively increases the maximum frequency associated with the CMOS technology. The circuit of the present invention is capable of producing gigahertz output frequencies.

Advantageously, the CMOS phase-locked loop circuit can be arranged such that the output of the exclusive-OR circuit provides an output signal having a frequency equal to an input signal frequency applied to the inputs of the first and second phase-locked loop means multiplied by twice the ratio M:N, where said first phase-locked loop means has a divide-by-N circuit and said second phase-loop means has a divide-by-M circuit.

In a first embodiment, the first and second phase-locked loop sub-circuits are arranged in a master/slave relationship in which a voltage-controlled oscillator of the first sub-circuit drives the second sub-circuit.

In a second embodiment, the first and second phase-locked loop sub-circuits arranged in parallel, each sub-circuit having its own voltage-controlled oscillator.

The present invention therefore advantageously provides a high-frequency phase locked loop circuit, which may be implemented in CMOS technology.

The invention is described further hereinafter, by way of example only, with reference to the accompanying drawings in which:
Fig. 1 is a block diagram of a computer circuit including a circuit embodying the present invention;
Fig. 2 comprises wave form diagrams illustrating the operation of a circuit embodying the present invention; and
Fig. 3 is a block diagram of a computer circuit including another embodiment of the present invention.

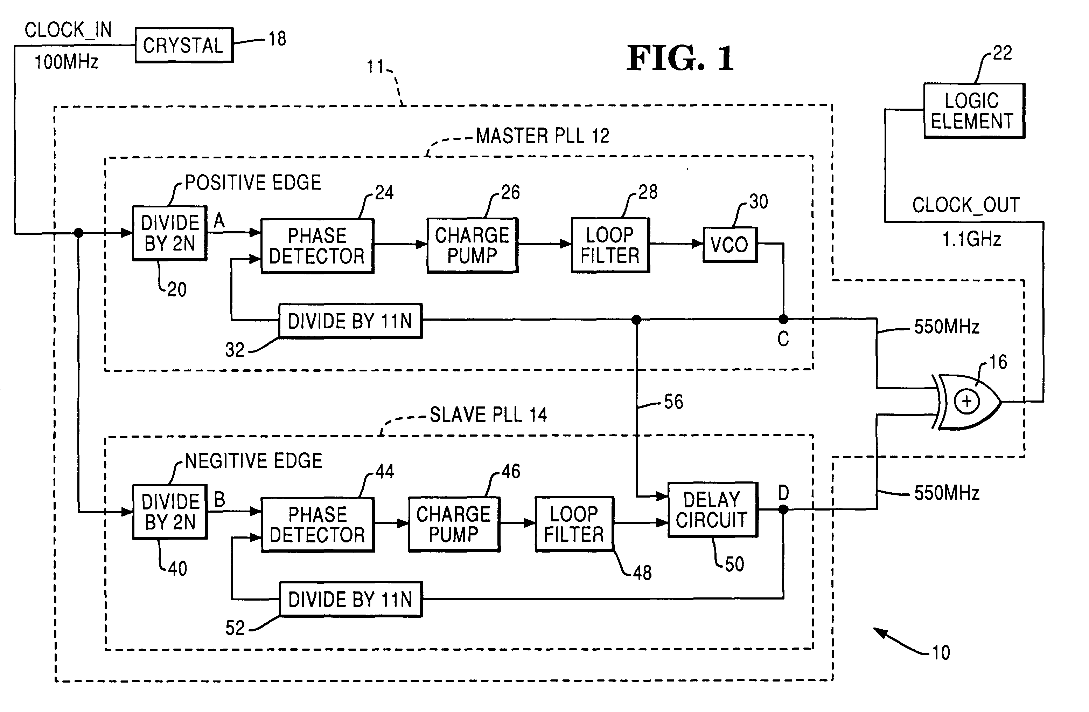

Referring now to Fig. 1, there is illustrated a computer system 10 which includes a phase-locked loop (PLL) circuit 11, a crystal 18, and logic element 22.

The PLL circuit 11 provides a signal CLOCK_OUT to the logic element 22.

The crystal 18 provides a signal CLOCK_IN to the PLL circuit 11.

The logic element 22 may be any computer component that requires a clock signal.

In more detail, the PLL circuit 11 includes a PLL sub-circuit 12, a PLL sub-circuit 14, and an exclusive-OR gate 16.

The PLL sub-circuit 12 includes a divide-by-2N circuit 20, a phase detector 24, a charge pump 26, a loop filter 28, a voltage-controlled oscillator (VCO) 30, and a divide-by-11N circuit 32. The individual functions of the components 20, 24, 26, 28, 30, and 32 are well-known in the art.

The PLL sub-circuit 14 includes a divide-by-2N circuit 40, a phase detector 44, a charge pump 46, a loop filter 48, a delay circuit 50, and a divide-by-11N circuit 52. The individual functions of components 40, 44, 46, 48, 50, and 52 are also well-known in the art.

Since it does not include a voltage-controlled oscillator, the PLL sub-circuit 14 acts as a slave PLL circuit to the PLL sub-circuit 12. The PLL sub-circuit therefore acts as a master PLL circuit. The PLL sub-circuit 12 feeds the signal at node C to node D of the PLL sub-circuit 14 by way of a delay line connection 56.

The ratio 2:11 reflected in the divide-by-2N circuits 20 and 40, and the divide-by-11N circuits 32 and 52, is arbitrarily chosen based on a CLOCK_IN signal frequency of 100 MHz and an output frequency at nodes C and D of the master and slave PLL circuits 12 and 14 of 550 MHz. The present invention can readily employ other ratios for other frequency constraints. For example, a ratio of 2:10 with a 100 MHz CLOCK_IN signal produces a frequency of 500 MHz at nodes C and D, and a CLOCK_OUT signal frequency of 1.0 GHz. The multiplier N can be any number, but is preferably equal to one.

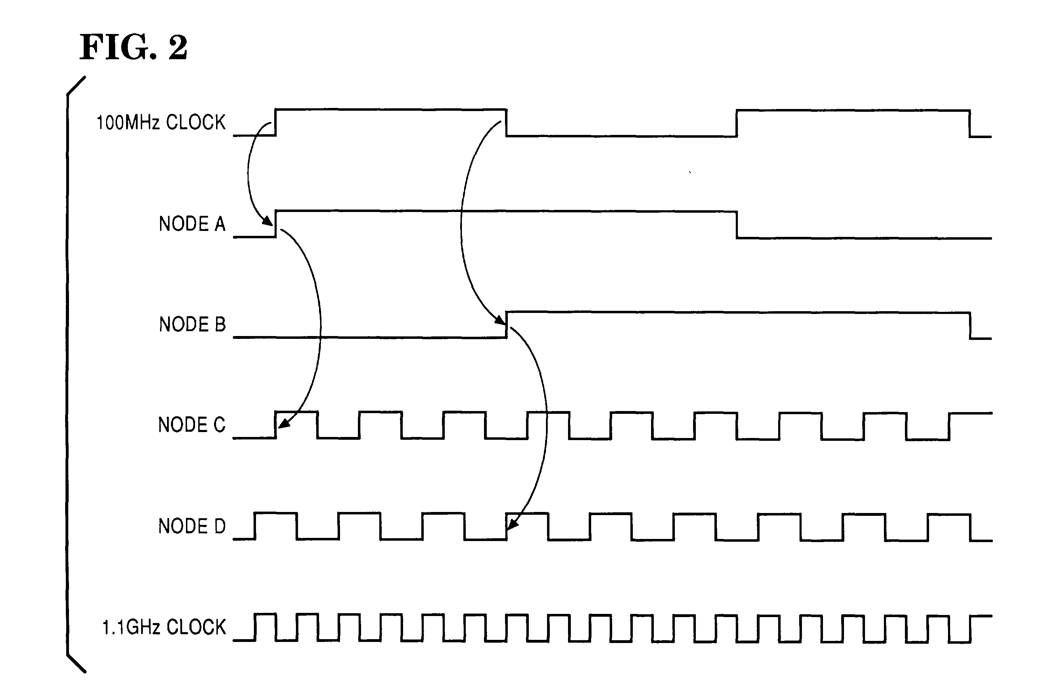

With reference also to Fig. 2, the master PLL sub-circuit 12 is triggered by a positive clock edge from the crystal 18, while the slave PLL 14 is triggered by a negative clock edge from crystal 18. Thus, with the multiplier N equal to one, the output frequencies at nodes A and B of the divide-by-2N circuits 20 and 40, respectively, is 50 MHz. The signals at nodes A and B are also ninety degrees apart in phase.

With N equal to one, the divide-by-llN circuit increases the 50 MHz frequency at node A to 550 MHz at node C. The delay circuit 50 feeds the 550 MHz signal at node C to node D over the delay circuit connection 56 (Fig. 1). The signal at node D is locked to the 50 MHz signal at node B, which is phase-shifted one-hundred and eighty degrees from the signal at node A. Thus, a phase difference of ninety degrees for the signals at nodes C and D is maintained.

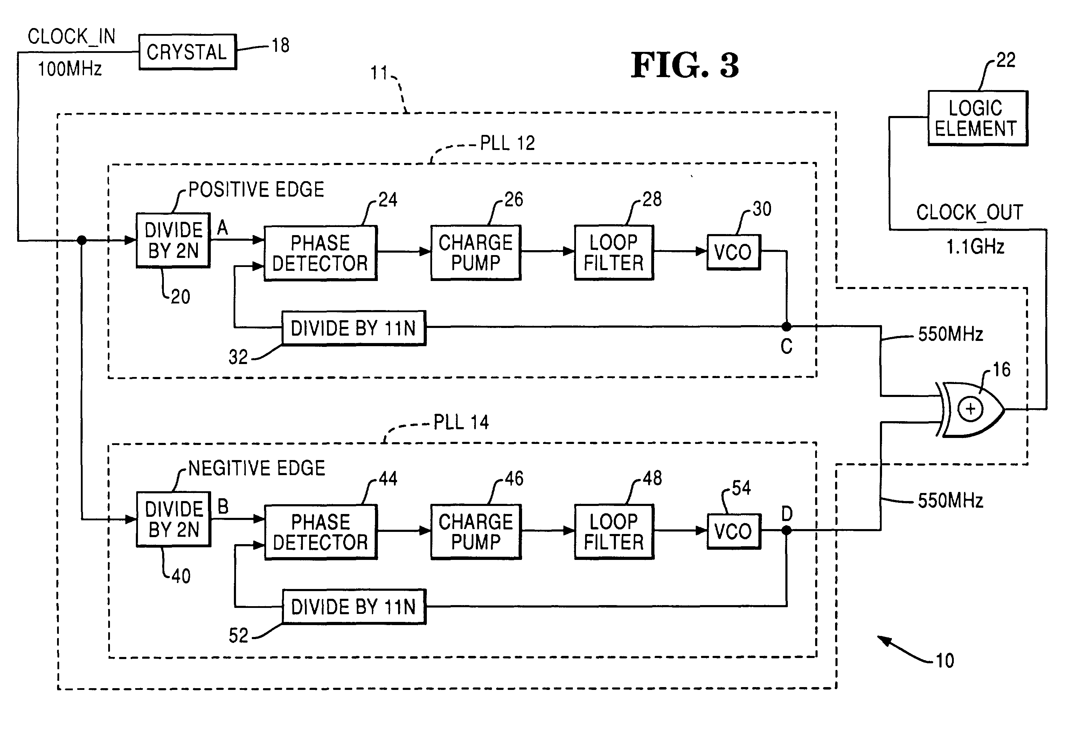

With reference further to Fig. 3, the delay circuit 50 and delay circuit connection 56 of Fig. 1 may be replaced at greater cost by another voltage-controlled oscillator 54. Thus, there is no master/slave relationship between the PLL sub-circuit 12 and the PLL sub-circuit 14. With N equal to one, the divide-by-llN circuits increase the 50 MHz frequency at nodes A and B to 550 MHz at nodes C and D respectively.

In both the embodiments of Figs. 1 and 3, the signals at nodes C and D are coupled to the exclusive-OR gate 16. Due to the ninety degree phase difference between the signals at nodes C and D, the exclusive-OR gate 16 is able to produce a CLOCK_OUT signal having double the frequency, or 1.1 GHz.

The invention is not restricted to the details of the foregoing embodiments.

## Claims

1. A phase locked loop circuit (11) characterised by first phase-locked loop means (12) having an input and an output, second phase-locked loop means (14) having an input coupled to the input of said first phase-locked loop (12) and having an output, and an exclusive-OR circuit (16) having first and second inputs coupled to the outputs of said first (12) and second (14) phase-locked loop means and having an output, wherein the circuit is arranged such that the said output of the exclusive-OR circuit (16) provides a clock signal.

2. A circuit as claimed in Claim 1, wherein the inputs of said first (12) and second (14) phase-locked loop means are coupled to a crystal (18) which produces a signal having a predetermined input frequency, and the output of said exclusive-OR circuit (16) is arranged to provide an output signal having an output frequency which is predetermined multiple of said predetermined input frequency.

3. A circuit as claimed in Claim 2, wherein said output frequency is greater than 500 MHz.

4. A circuit as claimed in Claim 2, wherein the output frequency is greater than 1 GHz.

5. A circuit as claimed in any one of Claims 1 to 4, wherein said first phase-locked loop means (12) comprises a divide-by-N circuit (20) providing the input to said first phase-locked loop means (12) and having an output, a phase detector means (24) having first and second inputs and an output wherein the first input is coupled to the output of said divide-by-N circuit (20), a charge pump (26) having an input coupled to the output of said phase detector means (24) and having an output, a loop filter (28) having an input coupled to the output of said charge pump (26) and having an output, a voltage-controlled oscillator (30) having an input coupled to the output of said loop filter (28) and to the first input of said exclusive-OR circuit (16), and a divide-by-M circuit (32) having an input coupled to the output of said voltage-controlled oscillator (30) and an output coupled to the second input of said phase detector means (24).

6. A circuit as claimed in any one of Claims 1 to 5, wherein said second phase-locked loop means (14) comprises a divide-by-O circuit (40) providing the input to said second phase-locked loop means (14) and having an output, a phase detector means (44) having first and second inputs and an output wherein the first input is coupled to the output of said divide-by-O circuit (40), a charge pump (46) having an input coupled to the output of said phase detector means (44) and having an output, a loop filter (48) having an input coupled to the output of said charge pump (46) and having an output, a voltage-controlled oscillator (54) having an input coupled to the output of said loop filter (48) and having an output coupled to the second input of said exclusive-OR circuit (16), and a divide-by-P circuit (52) having an input coupled to the output of said voltage-controlled oscillator (54) and an output coupled to the second input of said phase detector means (44).

7. A circuit as claimed in Claim 6, when dependent on Claim 5 and Claim 2, wherein the ratios M:N and P:O are equal to a common ratio, and the output of said exclusive-OR circuit (16) provides an output signal having an output frequency which is equal to the input frequency multiplied by twice said common ratio.

8. A circuit as claimed in any one of Claims 1 to 5, wherein said first phase-locked loop means (16) comprises a master phase-locked loop circuit and said second phase-locked loop means (14) comprises a slave phase-locked loop circuit.

9. A circuit as claimed in Claim 6, wherein said second phase-locked loop means (14) comprises a divide-by-O circuit (40) providing the input to said second phase-locked loop means (14) and having an output, a phase detector means (44) having first and second inputs and an output wherein the first input is coupled to said output of said divide-by-O circuit (40), a charge pump (46) having an input coupled to the output of said phase detector means (44) and having an output, a loop filter (48) having an input coupled to the output of said charge pump (46) and having an output, a delay circuit (50) having a first input coupled to the output of said loop filter (48), a second input coupled to the output of said voltage-controlled oscillator (30) of said first phase-locked loop means (12) and an output coupled to the second input of said exclusive-OR circuit (16), and a divide-by-P circuit (52) having an input coupled to the output of said delay circuit (50) and an output coupled to the second input of said phase detector means (44).

10. A circuit as claimed in Claim 9, when dependent on Claim 5 and Claim 2, wherein ratios M:N and P:O are equal to a common ratio, and the output of said exclusive-OR circuit (16) provides an output signal having an output frequency which is equal to the input frequency multiplied by twice said common ratio.

11. A circuit as claimed in Claim 7 or 10, wherein said divide-by-N circuit (30) triggers on a positive edge of said input signal from said crystal (18) and said divide-by-O circuit (40) triggers on a negative edge of said input signal from said crystal (18).

12. A circuit as claimed in any one of the preceding claims, wherein a signal at the first input of said exclusive-OR circuit (16) and a signal at the second input of said exclusive-OR circuit (16) differ in phase by ninety degrees.

13. A circuit as claimed in any one of the preceding claims and comprising a CMOS phase-locked loop circuit.

14. A system comprising a phase-locked loop circuit (11) as claimed in any one of the preceding claims, wherein a logic element (22) is coupled to the output of said exclusive-OR circuit (16).

15. A method of producing a clock signal characterised by the steps of producing a first signal having half the frequency of said clock signal by first phase-locked loop means (12), producing a second signal having half the frequency of said clock signal and differing in phase by ninety degrees from the first signal by second phase-locked loop means (14), and coupling the first and second signals to an exclusive-OR logic element (16).

## Patentansprüche

1. Phasenregelkreisschaltung (11), gekennzeichnet durch ein erstes Phasenregelkreismittel (12) mit einem Eingang und einem Ausgang, ein zweites Phasenregelkreismittel (14) mit einem Eingang, der mit dem Eingang des genannten ersten Phasenregelkreises (12) gekoppelt ist, und mit einem Ausgang, und eine Exklusiv-ODER-Schaltung (16) mit einem ersten und einem zweiten Eingang, die mit dem Ausgang des genannten ersten (12) und des genannten zweiten (14) Phasenregelkreises gekoppelt sind, und mit einem Ausgang, wobei die Schaltung so angeordnet ist, daß der genannte Ausgang der Exklusiv-ODER-Schaltung (16) ein Taktsignal erzeugt.

2. Schaltung nach Anspruch 1, bei der die Eingänge des genannten ersten (12) und des genannten zweiten (14) Phasenregelkreismittels mit einem Kristall (18) gekoppelt sind, der ein Signal mit einer vorbestimmten Eingangsfrequenz erzeugt, und der Ausgang der genannten Exklusiv-ODER-Schaltung (16) so angeordnet ist, daß er ein Ausgangssignal mit einer Ausgangsfrequenz erzeugt, die ein vorbestimmtes Vielfaches der genannten vorbestimmten Eingangsfrequenz ist.

3. Schaltung nach Anspruch 2, bei der die genannte Ausgangsfrequenz größer als 500 MHz ist.

4. Schaltung nach Anspruch 2, bei der die Ausgangsfrequenz größer als 1 GHz ist.

5. Schaltung nach einem der Ansprüche 1 bis 4, bei der das genannte erste Phasenregelkreismittel (12) folgendes umfaßt: eine Durch-N-Dividieren-Schaltung (20), die das Eingangssignal zu dem genannten ersten Phasenregelkreismittel (12) bereitstellt und einen Ausgang aufweist, ein Phasendetektormittel (24) mit einem ersten und einem zweiten Eingang sowie einem Ausgang, wobei der erste Eingang mit dem Ausgang der genannten Durch-N-Dividieren-Schaltung (20) gekoppelt ist, eine Ladungspumpe (26) mit einem Eingang, der mit dem Ausgang des genannten Phasendetektormittels (24) gekoppelt ist, und mit einem Ausgang, ein Schleifenfilter (28) mit einem Eingang, der mit dem Ausgang der genannten Ladungspumpe (26) gekoppelt ist, und mit einem Ausgang, einen spannungsgeregelten Oszillator (30) mit einem Eingang, der mit dem Ausgang des genannten Schleifenfilters (28) und mit dem ersten Eingang der genannten Exklusiv-ODER-Schaltung (16) gekoppelt ist, und eine Durch-M-Dividieren-Schaltung (32) mit einem Eingang, der mit dem Ausgang des genannten spannungsgeregelten Oszillators (30) gekoppelt ist, und mit einem Ausgang, der mit dem zweiten Eingang des genannten Phasendetektormittels (24) gekoppelt ist.

6. Schaltung nach einem der Ansprüche 1 bis 5, bei der das genannte zweite Phasenregelkreismittel (14) folgendes umfaßt: eine Durch-O-Dividieren-Schaltung (40), die das Eingangssignal zu dem genannten zweiten Phasenregelkreismittel (14) bereitstellt, und mit einem Ausgang, ein Phasendetektormittel (44) mit einem ersten und einem zweiten Eingang und einem Ausgang, wobei der erste Eingang mit dem Ausgang der genannten Durch-O-Dividieren-Schaltung (40) gekoppelt ist, eine Ladungspumpe (46) mit einem Eingang, der mit dem Ausgang des genannten Phasendetektormittels (44) gekoppelt ist, und mit einem Ausgang, ein Schleifenfilter (48) mit einem Eingang, der mit dem Ausgang der genannten Ladungspumpe (46) gekoppelt ist, und mit einem Ausgang, einen spannungsgeregelten Oszillator (54) mit einem Eingang, der mit dem Ausgang des genannten Schleifenfilters (48) gekoppelt ist, und mit einem Ausgang, der mit dem zweiten Eingang der genannten Exklusiv-ODER-Schaltung (16) gekoppelt ist, und eine Durch-P-Dividieren-Schaltung (52) mit einem Eingang, der mit dem Ausgang des genannten spannungsgeregelten Oszillators (54) gekoppelt ist, und einem Ausgang, der mit dem zweiten Eingang des genannten Phasendetektormittels (44) gekoppelt ist.

7. Schaltung nach Anspruch 6 in Abhängigkeit von Anspruch 5 und Anspruch 2, wobei die Verhältnisse M:N und P:O gleich einem gemeinsamen Verhältnis sind und der Ausgang der genannten Exklusiv-ODER-Schaltung (16) ein Ausgangssignal mit einer Ausgangsfrequenz bereitstellt, die gleich der Eingangsfrequenz multipliziert mit dem Zweifachen des genannten gemeinsamen Verhältnisses ist.

8. Schaltung nach einem der Ansprüche 1 bis 5, bei der das genannte erste Phasenregelkreismittel (16) eine Master-Phasenregelkreisschaltung umfaßt und das genannte zweite Phasenregelkreismittel (14) eine Slave-Phasenregelkreisschaltung umfaßt.

9. Schaltung nach Anspruch 6, bei der das genannte zweite Phasenregelkreismittel (14) folgendes umfaßt: eine Durch-O-Dividieren-Schaltung (40), die das Eingangssignal zu dem genannten zweiten Phasenregelkreismittel (14) bereitstellt, und mit einem Ausgang, ein Phasendetektormittel (44) mit einem ersten und einem zweiten Eingang und einem Ausgang, wobei der erste Eingang mit dem genannten Ausgang der genannten Durch-O-Dividieren-Schaltung (40) gekoppelt ist, eine Ladungspumpe (46) mit einem Eingang, der mit dem Ausgang des genannten Phasendetektormittels (44) gekoppelt ist, und mit einem Ausgang, ein Schleifenfilter (48) mit einem Eingang, der mit dem Ausgang der genannten Ladungspumpe (46) gekoppelt ist, und mit einem Ausgang, eine Verzögerungsschaltung (50) mit einem ersten Eingang, der mit dem Ausgang des genannten Schleifenfilters (48) gekoppelt ist, einem zweiten Eingang, der mit dem Ausgang des genannten spannungsgeregelten Oszillators (30) des genannten ersten Phasenregelkreismittels (12) gekoppelt ist, und einem Ausgang, der mit dem zweiten Eingang der genannten Exklusiv-ODER-Schaltung (16) gekoppelt ist, und eine Durch-P-Dividieren-Schaltung (52) mit einem Eingang, der mit dem Ausgang der genannten Verzögerungsschaltung (50) gekoppelt ist, und einem Ausgang, der mit dem zweiten Eingang des genannten Phasendetektormittels (44) gekoppelt ist.

10. Schaltung nach Anspruch 9 in Abhängigkeit von Anspruch 5 und Anspruch 2, wobei die Verhältnisse M:N und P:O gleich einem gemeinsamen Verhältnis sind und der Ausgang der genannten Exklusiv-ODER-Schaltung (16) ein Ausgangssignal mit einer Ausgangsfrequenz bereitstellt, die gleich der Eingangsfrequenz multipliziert mit dem Zweifachen des genannten gemeinsamen Verhältnisses ist.

11. Schaltung nach Anspruch 7 oder 10, bei der die genannte Durch-N-Dividieren-Schaltung (30) auf einer positiven Flanke des genannten Eingangssignals von dem genannten Kristall (18) ausgelöst wird und die genannte Durch-O-Dividieren-Schaltung (40) auf einer negativen Flanke des genannten Eingangssignals von dem genannten Kristall (18) ausgelöst wird.

12. Schaltung nach einem der vorherigen Ansprüche, bei der ein Signal am ersten Eingang der genannten Exklusiv-ODER-Schaltung (16) und ein Signal am zweiten Eingang der genannten Exklusiv-ODER-Schaltung (16) um neunzig Grad phasenverschoben sind.

13. Schaltung nach einem der vorherigen Ansprüche, umfassend eine CMOS-Phasenregelkreisschaltung.

14. System, umfassend eine Phasenregelkreisschaltung (11) nach einem der vorherigen Ansprüche, wobei ein Logikelement (22) mit dem Ausgang der genannten Exklusiv-ODER-Schaltung (16) gekoppelt ist.

15. Verfahren zum Erzeugen eines Taktsignals, gekennzeichnet durch die folgenden Schritte: Erzeugen eines ersten Signals mit der Hälfte der Frequenz des genannten Taktsignals mit Hilfe des ersten Phasenregelkreismittels (12), Erzeugen eines zweiten Signals mit der Hälfte der Frequenz des genannten Taktsignals und mit einer Phasenverschiebung von neunzig Grad von dem ersten Signal mit Hilfe' des zweiten Phasenregelkreismittels (14), und Koppeln des ersten und des zweiten Signals mit einem Exklusiv-ODER-Logikelement (16).

## Revendications

1. Circuit de boucle asservie en phase (11) caractérisé par un premier moyen de boucle asservie en phase (12) ayant une entrée et une sortie, un deuxième moyen de boucle asservie en phase (14) ayant une entrée couplée à l'entrée de ladite première boucle asservie en phase (12) et ayant une sortie, et un circuit OU exclusif (16) ayant des première et deuxième entrées couplées aux sorties desdits premier (12) et deuxième (14) moyens de boucle asservie en phase et ayant une sortie, dans lequel le circuit est disposé de telle sorte que ladite sortie du circuit OU exclusif (16) fournisse un signal d'horloge.

2. Circuit selon la revendication 1, dans lequel les entrées desdits premier (12) et deuxième (14) moyens de boucle asservie en phase sont couplées à un quartz (18) qui produit un signal ayant une fréquence d'entrée prédéterminée, et la sortie dudit circuit OU exclusif (16) est disposée pour fournir un signal de sortie ayant une fréquence de sortie qui est un multiple prédéterminé de ladite fréquence d'entrée prédéterminée.

3. Circuit selon la revendication 2, dans lequel ladite fréquence de sortie est supérieure à 500 MHz.

4. Circuit selon la revendication 2, dans lequel ladite fréquence de sortie est supérieure à 1 GHz.

5. Circuit selon l'une quelconque des revendications 1 à 4, dans lequel ledit premier moyen de boucle asservie en phase (12) comprend un circuit diviseur par N (20) fournissant l'entrée audit premier moyen de boucle asservie en phase (12) et ayant une sortie, un moyen de détection de phase (24) ayant des première et deuxième entrées et une sortie dans lequel la première entrée est couplée à la sortie dudit circuit diviseur par N (20), une pompe de charge (26) ayant une entrée couplée à la sortie dudit moyen de détection de phase (24) et ayant une sortie, un filtre de boucle (28) ayant une entrée couplée à la sortie de ladite pompe de charge (26) et ayant une sortie, un oscillateur commandé en tension (30) ayant une entrée couplée à la sortie dudit filtre de boucle (28) et à la première entrée dudit circuit OU exclusif (16), et un circuit diviseur par M (32) ayant une entrée couplée à la sortie dudit oscillateur commandé en tension (30) et une sortie couplée à la deuxième entrée dudit moyen de détection de phase (24).

6. Circuit selon l'une quelconque des revendications 1 à 5, dans lequel ledit deuxième moyen de boucle asservie en phase (14) comprend un circuit diviseur par O (40) fournissant l'entrée audit deuxième moyen de boucle asservie en phase (14) et ayant une sortie, un moyen de détection de phase (44) ayant des première et deuxième entrées et une sortie dans lequel la première entrée est couplée à la sortie dudit circuit diviseur par O (40), une pompe de charge (46) ayant une entrée couplée à la sortie dudit moyen de détection de phase (44) et ayant une sortie, un filtre de boucle (48) ayant une entrée couplée à la sortie de ladite pompe de charge (46) et ayant une sortie, un oscillateur commandé en tension (54) ayant une entrée couplée à la sortie dudit filtre de boucle (48) et ayant une sortie coùplée à la deuxième entrée dudit circuit OU exclusif (16), et un circuit diviseur par P (52) ayant une entrée couplée à la sortie dudit oscillateur commandé en tension (54) et une sortie couplée à la deuxième entrée dudit moyen de détection de phase (44).

7. Circuit selon la revendication 6, lorsque dépendante des revendications 5 et 2, dans lequel les rapports M:N et P:O sont égaux à un rapport commun, et la sortie dudit circuit OU exclusif (16) fournit un signal de sortie ayant une fréquence de sortie qui est égale à la fréquence d'entrée multipliée par deux fois ledit rapport commun.

8. Circuit selon l'une quelconque des revendications 1 à 5, dans lequel ledit premier moyen de boucle asservie en phase (16) comprend un circuit de boucle asservie en phase maître et ledit deuxième moyen de boucle asservie en phase (14) comprend un circuit de boucle asservie en phase esclave.

9. Circuit selon la revendication 6, dans lequel ledit deuxième moyen de boucle asservie en phase (14) comprend un circuit diviseur par O (40) fournissant l'entrée audit deuxième moyen de boucle asservie en phase (14) et ayant une sortie, un moyen de détection de phase (44) ayant des première et deuxième entrées et une sortie dans lequel la première entrée est couplée à ladite sortie dudit circuit diviseur par O (40), une pompe de charge (46) ayant une entrée couplée à la sortie dudit moyen de détection de phase (44) et ayant une sortie, un filtre de boucle (48) ayant une entrée couplée à la sortie de ladite pompe de charge (46) et ayant une sortie, un circuit à retard (50) ayant une première entrée couplée à la sortie dudit filtre de boucle (48), une deuxième entrée couplée à la sortie dudit oscillateur commandé en tension (30) dudit premier moyen de boucle asservie en phase (12) et une sortie couplée à la deuxième entrée dudit circuit OU exclusif (16), et un circuit diviseur par P (52) ayant une entrée couplée à la sortie dudit circuit à retard (50) et une sortie couplée à la deuxième entrée dudit moyen de détection de phase (44).

10. Circuit selon la revendication 9, lorsque dépendante des revendications 5 et 2, dans lequel les rapports M:N et P:O sont égaux à un rapport commun, et la sortie dudit circuit OU exclusif (16) fournit un signal de sortie ayant une fréquence de sortie qui est égale à la fréquence d'entrée multipliée par deux fois ledit rapport commun.

11. Circuit selon la revendication 7 ou 10, dans lequel ledit circuit diviseur par N (30) se déclenche sur un flanc positif dudit signal d'entrée provenant dudit quartz (18) et ledit circuit diviseur par O (40) se déclenche sur un flanc négatif dudit signal d'entrée provenant dudit quartz (18).

12. Circuit selon l'une quelconque des revendications précédentes, dans lequel un signal au niveau de la première entrée dudit circuit OU exclusif (16) et un signal au niveau de la deuxième entrée dudit circuit OU exclusif (16) diffèrent en phase par quatre-vingt dix degrés.

13. Circuit selon l'une quelconque des revendications précédentes et comprenant un circuit de boucle asservie en phase CMOS.

14. Système comprenant un circuit de boucle asservie en phase (11) selon l'une quelconque des revendications précédentes, dans lequel un élément logique (22) est couplé à la sortie dudit circuit OU exclusif (16).

15. Procédé de production d'un signal d'horloge caractérisé par les étapes de production d'un premier signal ayant la moitié de la fréquence dudit signal d'horloge par un premier moyen de boucle asservie en phase (12), production d'un deuxième signal ayant la moitié de la fréquence dudit signal d'horloge et différant en phase de quatre-vingt dix degrés par rapport au premier signal par un deuxième moyen de boucle asservie en phase (14), et couplage des premier et deuxième signaux à un élément logique OU exclusif (16).
